(19) Europäisches Patentamt
European Patent Office
Office européen des brevets

(11) **EP 4 614 889 A1**

(12) **EUROPEAN PATENT APPLICATION**
published in accordance with Art. 153(4) EPC

(43) Date of publication:
**10.09.2025 Bulletin 2025/37**

(21) Application number: **23915732.4**

(22) Date of filing: **28.11.2023**

(51) International Patent Classification (IPC):
***H04L 25/03*** *(2006.01)*

(52) Cooperative Patent Classification (CPC):
**H03M 13/45; H04B 7/0413; H04L 25/03**

(86) International application number:
**PCT/CN2023/134714**

(87) International publication number:
**WO 2024/148974 (18.07.2024 Gazette 2024/29)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **12.01.2023 CN 202310076293**

(71) Applicant: **Sanechips Technology Co., Ltd.**
**Shenzhen, Guangdong 518055 (CN)**

(72) Inventor: **GUO, Zhenwei**
**Shenzhen, Guangdong 518055 (CN)**

(74) Representative: **Canzler & Bergmeier Patentanwälte Partnerschaft mbB**
**Despag-Straße 6**
**85055 Ingolstadt (DE)**

(54) **SPHERE DECODING DETECTION METHOD AND APPARATUS, AND ELECTRONIC DEVICE AND READABLE STORAGE MEDIUM**

(57) Disclosed in the present application are a sphere decoding detection method and apparatus, and an electronic device and a readable storage medium. The method comprises: performing orthogonal triangular QR decomposition on a channel response matrix, so as to obtain a Q matrix and an R matrix, wherein columns in the Q matrix are arranged according to the magnitude of channel energy; according to the Q matrix and the R matrix, determining a target equalization signal; executing an ML path search process according to the target equalization signal, so as to select N branches with the minimum metric as survivor paths; performing an ML complement path search on the survivor paths, so as to obtain ML complement paths; and using the survivor path with the minimum metric as an ML path, and obtaining likelihood ratio information of each bit of each symbol of each layer according to the ML path and the ML complement paths.

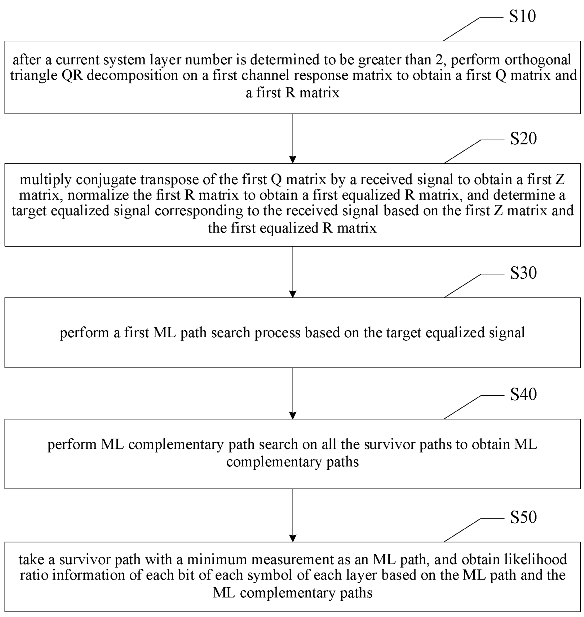


FIG. 1

EP 4 614 889 A1

## Description

CROSS REFERENCE TO RELATED APPLICATIONS

The present disclosure claims the priority to Chinese Patent Application No. 202310076293.0 entitled "SPHERE DECODING DETECTION METHOD AND APPARATUS, AND ELECTRONIC DEVICE AND READABLE STORAGE MEDIUM" filed on January 12, 2023, the contents of which are incorporated herein by reference in their entirety.

TECHNICAL FIELD

The present disclosure relates to the technical field of wireless communications, and in particular, to a sphere decoding detection method and apparatus, an electronic device, and a readable storage medium.

BACKGROUND

A core concept of the Multiple Input Multiple Output (MIMO) technology is to make use of the spatial freedom provided by multiple transmitting antennas and multiple receiving antennas to effectively improve spectrum efficiency of a wireless communication system, so as to increase transmission rate and improve communication quality. Since the MIMO technology can greatly increase data throughput and transmission distance of the system without increasing bandwidth or total transmission power consumption, the MIMO technology attracts a lot of attention in recent years.

Sphere Decoding (SD) detection has decoding performance approaching to that of Maximum Likelihood (ML) detection and has moderate complexity, and thus is a relatively ideal signal detection method. However, the existing SD algorithm still has many shortcomings, which affects the practical application of the algorithm. Therefore, how to reduce computational complexity of the SD algorithm while maintaining decoding detection performance is an urgent problem to be solved.

SUMMARY

The present disclosure provides a sphere decoding detection method and apparatus, an electronic device, and a readable storage medium, so as to reduce the computational complexity of the sphere decoding algorithm while maintaining the decoding detection performance.

The present disclosure provides a sphere decoding detection method, including: performing, after a current system layer number is determined to be greater than 2, orthogonal triangle QR decomposition on a first channel response matrix to obtain a first Q matrix and a first R matrix, wherein columns in the first Q matrix are arranged based on magnitudes of channel energy, and a column with minimum channel energy is arranged at a top layer of sphere decoding search; multiplying conjugate transpose of the first Q matrix by a received signal to obtain a first Z matrix, normalizing the first R matrix to obtain a first equalized R matrix, and determining a target equalized signal corresponding to the received signal based on the first Z matrix and the first equalized R matrix; performing a first maximum likelihood path search process based on the target equalized signal, wherein the first maximum likelihood path search process is dividing all nodes of the top layer into $B_{Nt-1}$ blocks each including one representative point and at least one extended point, performing path detection on each of the representative points, selecting $Ka_{Nt-1}$ representative points with minimum measurements, taking the blocks corresponding to the selected representative points as survivor blocks, performing path detection on the at least one extended point near the representative point in each of the survivor blocks, and selecting $N_1$ branches with minimum measurements as survivor paths, wherein $B_{Nt-1}$, $Ka_{Nt-1}$, and $N_1$ are all natural numbers, and $B_{Nt-1}>Ka_{Nt-1}$; performing maximum likelihood complementary path search on all the survivor paths to obtain maximum likelihood complementary paths; and taking a survivor path with a minimum measurement as a maximum likelihood path, and obtaining likelihood ratio information of each bit of each symbol of each layer based on the maximum likelihood path and the maximum likelihood complementary paths.

The present disclosure further provides a sphere decoding detection apparatus, including: a QR decomposition module configured to perform, after a current system layer number is determined to be greater than 2, orthogonal triangle QR decomposition on a first channel response matrix to obtain a first Q matrix and a first R matrix, wherein columns in the first Q matrix are arranged based on magnitudes of channel energy, and a column with minimum channel energy is arranged at a top layer of sphere decoding search; an equalized signal calculation module configured to multiply conjugate transpose of the first Q matrix by a received signal to obtain a first Z matrix, normalize the first R matrix to obtain a first equalized R matrix, and determine a target equalized signal corresponding to the received signal based on the first Z matrix and the first equalized R matrix; a maximum likelihood path search module configured to perform a first maximum likelihood path search process based on the target equalized signal, wherein the first maximum likelihood path search process is dividing all nodes of the top layer into $B_{Nt-1}$ blocks each including one representative point and at least one extended point, performing path detection on each of the representative points, selecting $Ka_{Nt-1}$ representative points with minimum measurements, taking the blocks corresponding to the selected representative points as survivor blocks, performing path detection on the at least one extended point near the representative point in each of the survivor blocks, and selecting $N_1$ branches with minimum measurements as survivor paths, wherein $B_{Nt-1}$, $Ka_{Nt-1}$, and $N_1$ are all natural numbers, and $B_{Nt-1} > Ka_{Nt-1}$; a maximum likelihood complementary path search module configured to perform maximum likelihood complementary path search on all the survivor paths to obtain maximum likelihood complementary paths; and a soft information calculation module configured to take a survivor path with a minimum measurement as a maximum likelihood path, and obtain likelihood ratio information of each bit of each symbol of each layer based on the maximum likelihood path and the maximum likelihood complementary paths.

The present disclosure further provides an electronic device, including: a memory, a processor, and a computer program stored on the memory, wherein the computer program, when executed by the processor, causes the processor to implement the above sphere decoding detection method.

The present disclosure further provides a computer-readable storage medium having stored thereon a computer program which, when executed by a processor, causes the processor to implement the above sphere decoding detection method.

## BRIEF DESCRIPTION OF DRAWINGS

In order to explain the technical solutions in the embodiments of the present disclosure or the technical solutions in the related technology more clearly, the drawings for the description of the embodiments or the related technology will be briefly described below. Apparently, the drawings described below are merely for some embodiments of the present disclosure, and other drawings can be derived by those of ordinary skill in the art from the structures shown in the drawings described below without any inventive work. In the drawings:

FIG. 1 is a flowchart illustrating an SD detection method according to an embodiment of the present disclosure;
FIG. 2 is another flowchart illustrating an SD detection method according to an embodiment of the present disclosure;
FIG. 3 is a schematic diagram of an SD detection process for MIMO according to an embodiment of the present disclosure;
FIG. 4 is a schematic diagram of QR decomposition when a system layer number is equal to 2 according to an embodiment of the present disclosure;
FIG. 5 is a schematic diagram of implementation scenarios of QR decomposition in cases of different system layer numbers according to an embodiment of the present disclosure;
FIG. 6 is a flowchart of preprocessing according to an embodiment of the present disclosure;
FIG. 7 is a flowchart of SD search according to an embodiment of the present disclosure;
FIG. 8 is a schematic diagram of an implementation architecture for search and soft bit calculation according to an embodiment of the present disclosure;
FIG. 9 is a block diagram of an SD detection apparatus according to an embodiment of the present disclosure;
FIG. 10 is a schematic structural diagram of a wireless receiving device supporting Multiple Input Multiple Output-Orthogonal Frequency Division Multiplex (MIMO-OFDM) according to an embodiment of the present disclosure; and
FIG. 11 is a schematic diagram of a hardware structure of an electronic device according to an embodiment of the present disclosure.

The implementation of the objectives, the functional features and advantages of the present disclosure will be further described in conjunction with the embodiments and with reference to the drawings.

## DETAIL DESCRIPTION OF EMBODIMENTS

It should be understood that the specific embodiments described herein are merely intended to explain the present disclosure, rather than limiting the present disclosure.

The technical solutions of the embodiments of the present disclosure are clearly and thoroughly described below in conjunction with the drawings for the embodiments of the present disclosure. Apparently, the embodiments described herein are merely some embodiments of the present disclosure, and do not cover all embodiments. All other embodiments derived by those of ordinary skill in the art from the embodiments described in the present disclosure without any inventive work fall within the scope of the present disclosure.

It should be noted that the directional indications (such as "on", "under", "left", "right", "front", "back" ......) in the embodiments of the present disclosure are merely used for explaining a relative positional relationship between components and motions of the components in a specific posture (as shown in the drawings), and if the specific posture is changed, the directional indications are changed accordingly.

In the present disclosure, unless expressly stated and limited otherwise, the terms "connect" and "fix" should be understood broadly, for example, the term "fix" may refer to fixed connection, detachable connection, or integration, may refer to mechanic connection or electrical connection, and may refer to direct connection, indirect connection through an intermediate medium, communication between interiors of two elements, or an interaction relationship between two elements, unless expressly limited otherwise. The specific meanings of the above terms in the present disclosure can be understood by those of ordinary skill in the art according to specific cases.

In addition, the description involving the terms "first", "second" and the like in the present disclosure is merely for the purpose of description, and should not be understood as indicating or implying relative importance or implicitly indicating the number of the indicated technical features. Thus, a feature defined by "first" or "second" may explicitly or implicitly include at least one feature. Moreover, the technical solutions in the embodiments may be combined with each other, but should be combined based on the premise that the combinations can be implemented by those of ordinary skill in the art. When a combination of the technical solutions causes contradiction or cannot be implemented, such combination should not be considered to exist, and is not within the scope of the present disclosure.

Among the commonly used MIMO reception detection methods, the Zero-Forcing (ZF) response method and the Minimum Mean Square Error (MMSE) method are low in complexity but the worst in performance. The Maximum Likelihood (ML) detection algorithm is an algorithm with better performance among the MIMO reception detection methods, but the ML detection algorithm has the highest complexity, which is not favorable for engineering implementation demanding real-time processing.

The Sphere Decoding (SD) essentially constructs an ML detection as searching for an optimal path on a source-signal constellation-point tree, with constraints continuously enforced during the search. An operating principle of the SD is as follows: a sphere with a received signal point as a center is preset first in a received signal space, the sphere is then mapped to be an ellipsoid in a transmitted signal space, a possible transmitted signal point is searched for in the ellipsoid, and once one transmitted signal point is found, the preset sphere is shrunk by taking a distance between a mapping point of the found signal point and the received signal as a radius, so as to enable a subsequent search to be performed within a smaller range.

The SD detection has the decoding performance approaching to that of the ML detection and has the moderate complexity, and thus is a relatively ideal signal detection method. However, the existing SD algorithm still has many shortcomings, which affects the practical application of the algorithm. The overall search complexity of the existing SD algorithm is still relatively high, for example, as the number of layers (the number of transmitting antennas) supported by the 4$^{th}$ generation mobile communication technology (4G)/the 5$^{th}$ generation mobile communication technology (5G) is increased and a modulation order is increased, the computation amount of the SD algorithm is increased exponentially, which is not favorable for engineering implementation and low-cost requirements. Therefore, how to reduce the computational complexity of the SD algorithm while maintaining the decoding detection performance is an urgent problem to be solved.

An embodiment of the present disclosure provides an SD detection method, and FIG. 1 is a flowchart illustrating the SD detection method according to the embodiment of the present disclosure. Referring to FIG. 1, the SD detection method includes the following operations S10 to S50.

At operation S 10, after a current system layer number is determined to be greater than 2, orthogonal triangle QR decomposition is performed on a first channel response matrix to obtain a first Q matrix and a first R matrix, columns in the first Q matrix are arranged based on magnitudes of channel energy, and a column with minimum channel energy is arranged at a top layer of SD search.

According to the embodiment of the present disclosure, the first Q matrix is a unitary matrix, and the first R matrix is an upper triangular matrix.

At operation S20, conjugate transpose of the first Q matrix is multiplied by a received signal to obtain a first Z matrix, the first R matrix is normalized to obtain a first equalized R matrix, and a target equalized signal corresponding to the received signal is determined based on the first Z matrix and the first equalized R matrix.

According to the embodiment of the present disclosure, by normalizing the first R matrix in a preprocessing stage, computation amount and implementation complexity in a search stage can be greatly reduced.

Specifically, normalizing the first R matrix to obtain the first equalized R matrix includes: multiplying the first R matrix by a constellation-point modulation amplitude factor to obtain a normalized first R matrix, and taking the normalized first R matrix as the first equalized R matrix.

At operation S30, a first ML path search process is performed based on the target equalized signal.

According to the embodiment of the present disclosure, the first ML path search process is: dividing all nodes of the top layer into $B_{Nt-1}$ blocks each including one representative point and at least one extended point, performing path detection on each of the representative points, selecting $Ka_{Nt-1}$ representative points with minimum measurements, taking the blocks corresponding to the selected representative points as survivor blocks, performing path detection on the extended point near the representative point in each of the survivor blocks, and selecting $N_1$ branches with minimum measurements as survivor paths, where $B_{Nt-1}$, $Ka_{Nt-1}$, and $N_1$ are all natural numbers, and $B_{Nt-1} > Ka_{Nt-1}$.

It should be noted that performing path detection on each of the representative points and selecting the $Ka_{Nt-1}$ representative points with the minimum measurements refers to: performing path extension on each of the representative points, sorting generated branches in ascending order of the measurements, and selecting the representative points of the first $Ka_{Nt-1}$ branches. Performing path detection on the extended point near the representative point in each of the survivor blocks and selecting the $N_1$ branches with the minimum measurements as the survivor paths refers to: performing path extension on the extended point near the representative point in each of the survivor blocks, sorting all generated branches in ascending order of the measurements, and selecting the first $N_1$ branches as the survivor paths.

According to the embodiment of the present disclosure, if the extended points corresponding to different representative points are repeated, the repeated extended points are subjected to calculation merely once, that is, repeated calculation is avoided.

According to the embodiment of the present disclosure, constellation points in the blocks are evenly divided based on a constellation diagram during block division.

According to the embodiment of the present disclosure, the measurement is Euclidean distance.

It should be noted that, in addition to being represented by the Euclidean distance, the measurement described herein may be represented by calculation results of other calculation methods simplifying the Euclidean distance formula, the calculation results of other calculation methods of simplified Euclidean distance formula approximate to a calculation result of the Euclidean distance formula, and a square calculation in the Euclidean distance formula is changed to other calculation methods that are easy to be implemented by hardware.

According to the embodiment of the present disclosure, dividing all the nodes of the top layer into the $B_{Nt-1}$ blocks includes: generating a constellation diagram based on the target equalized signal, and dividing all the nodes of the top layer into the $B_{Nt-1}$ blocks based on the constellation diagram.

Performing path detection on the extended point near the representative point in each of the survivor blocks includes: performing extended search on the extended point around the representative point in each of the survivor blocks, where the extended point subjected to extended search in each of the survivor blocks is uniformly extended outwards by taking the representative point as a center.

At operation S40, ML complementary path search is performed on all the survivor paths to obtain ML complementary paths.

Illustratively, performing ML complementary path search on all the survivor paths to obtain the ML complementary paths includes: for each layer below the top layer, performing path extension on all the survivor paths, and selecting, from branches generated by path extension, the branches with minimum measurements as the ML complementary paths.

According to the embodiment of the present disclosure, path extension refers to: for nodes of each layer above a layer to be subjected to complementary search, the nodes of the survivor paths in path detection are reused; and for nodes below the layer to be subjected to complementary search, path extension is performed until to leaf nodes by adopting a node selection principle consistent with that used for a search for an ML path.

At operation S50, a survivor path with a minimum measurement is taken as an ML path, and likelihood ratio information of each bit of each symbol of each layer is obtained based on the ML path and the ML complementary paths.

At present, most related detection methods support two-layer detection, and as the number of the layers supported by the 4G/5G is increased from two to four or even to eight, improvements in modulation mode include Quadrature Phase Shift Keying (QPSK), 16 Quadrature Amplitude Modulation (16QAM), 64QAM, 256QAM, 1024QAM, and up to 4096QAM. According to the related methods, the computation amount is increased exponentially with the increase of the number of the supported layers. Meanwhile, the computational complexity is increased linearly with the increase of the modulation modes, that is, the complexity of the conventional SD is increased exponentially with antenna configuration and modulation order, which is not favorable for the engineering implementations and the low-cost requirements.

According to the embodiment of the present disclosure, after the current system layer number is determined to be greater than 2, orthogonal triangle QR decomposition is performed on the first channel response matrix to obtain the first Q matrix and the first R matrix, where the columns in the first Q matrix are arranged based on the magnitudes of channel energy, and the column with the minimum channel energy is arranged at the top layer of SD search, so that in a QR decomposition stage, when the layer number is greater than 2, the columns of the H matrix are sorted based on the energy (the number of transmitting antennas corresponds to the number of the columns), and the layer with the minimum energy is placed at the topmost layer of SD search; the conjugate transpose of the first Q matrix is multiplied by the received signal to obtain the first Z matrix, the first R matrix is normalized to obtain the first equalized R matrix, and the target equalized signal corresponding to the received signal is determined based on the first Z matrix and the first equalized R matrix, so that the R matrix is normalized in the preprocessing stage, and the computation amount and the implementation complexity in the search stage are greatly reduced; the first ML path search process is performed based on the target equalized signal as follows: dividing all the nodes of the top layer into the $B_{Nt-1}$ blocks each including one representative point and at least one extended point, performing path detection on each of the representative points, selecting the $Ka_{Nt-1}$ representative points with the minimum measurements, taking the blocks corresponding to the selected representative points as the survivor blocks, performing path detection on the extended point near the representative point in each of the survivor blocks, and selecting the $N_1$ branches with the minimum measurements as the survivor paths, so that, by adopting the block search method for the top layer, the search merely needs to be performed on part of the required constellation points instead of all the constellation points (i.e., all the nodes) of the top layer in the ML path search process in the search stage, which effectively reduces decoding computation amount of an application scenario where a modulation order is greater than 256QAM, and reduces the computational complexity of the SD algorithm; and ML complementary path search is performed on all the survivor paths to obtain the ML complementary paths, so that an SD search process including the ML path search operation and the ML complementary path search operation is provided in the search stage, the overall search complexity of an application scenario where the number of the supported layers is greater than 2 is effectively reduced, and the computational complexity of the SD algorithm is further reduced. The embodiment of the present disclosure provides a pipeline fusion architecture for an SD detection process for MIMO, which effectively reduces hardware implementation resources and power consumption, and can meet requirements of real-time performance and throughput rate, thereby reducing the computational complexity of the SD algorithm while maintaining the decoding detection performance.

According to the embodiment of the present disclosure, after determining the target equalized signal corresponding to the received signal based on the first Z matrix and the first equalized R matrix (i.e., operation S20), the method further includes: in response to a modulation mode of a current system being a first modulation mode, performing the operation of performing the first ML path search process based on the target equalized signal (i.e., operation S30), where a modulation order of the first modulation mode greater than or equal to a preset value; and in response to the modulation mode of the current system being a second modulation mode, performing a second ML path search process based on the target equalized signal, where the second ML path search process is performing path detection on all the nodes of the top layer and selecting $N_2$ branches with minimum measurements as the survivor paths, a modulation order of the second modulation mode is less than the preset value, and $N_2$ is a natural number. Then, the operation of performing ML complementary path search on all the survivor paths to obtain the ML complementary paths (i.e., operation S40) is performed.

According to the embodiment of the present disclosure, the modulation order of the first modulation mode is greater than or equal to the preset value, and the modulation order of the second modulation mode is less than the preset value. The preset value may be set based on actual situations, which is not particularly limited in the present disclosure. In one embodiment, the preset value may be 256; and in the other embodiment, the preset value may be 64.

According to the embodiment of the present disclosure, when the modulation mode of the current system is determined to be the first modulation mode, the first ML path search process is performed based on the target equalized signal, where the modulation order of the first modulation mode is greater than or equal to the preset value; and when the modulation mode of the current system is determined to be the second modulation mode, the second ML path search process is performed based on the target equalized signal, thereby providing the SD search processes for the different modulation modes. When the modulation order is greater than or equal to the preset value (for example, the preset value is 256QAM), the modulation mode is a high-order modulation mode (i.e., the first modulation mode), and the SD computation amount under the modulation mode is relatively large, so the block search method for the top layer is adopted to reduce the SD computation amount; and when the modulation order is less than the preset value, the modulation mode is a low-order modulation mode (i.e., the second modulation mode), and the SD computation amount under the modulation mode is relatively small, so that the block search method for the top layer is not needed, all the constellation points of the top layer can be subjected to the search, and the block division is not needed. Thus, the decoding detection performance of SD is effectively ensured on the basis of reducing the SD computation amount, so that the SD search processes according to the embodiment of the present disclosure can approach to the theoretical ML detection performance, and can be applied to the detection methods for MIMO under the condition that the number of layers and the modulation modes are continuously increased in the current and future wireless communication systems, including the wireless communication systems of 5G evolution, Wireless Fidelity (WIFI) evolution, and the current 4G and 5G. Meanwhile, the complexity is low, the hardware implementation is facilitated, and the hardware implementation resources and power consumption is effectively reduced.

An embodiment of the present disclosure further provides an SD detection method, and FIG. 2 is another flowchart illustrating the SD detection method according to the embodiment of the present disclosure. Referring to FIG. 2, the SD detection method includes the following operations S61 to S65.

At operation S61, after the current system layer number is determined to be equal to 2, column swapping is performed on a second channel response matrix to obtain a column-swapped second channel response matrix, orthogonal triangle QR decomposition is performed on the second channel response matrix before column swapping to obtain a second Q matrix and a second R matrix, and orthogonal triangle QR decomposition is performed on the column-swapped second channel response matrix to obtain a second $Q_s$ matrix and a second $R_s$ matrix.

At operation S62, conjugate transpose of the second Q matrix is multiplied by the received signal to obtain a second Z matrix, the second R matrix is normalized to obtain a second equalized R matrix, and a first equalized signal corresponding to the received signal is determined based on the second Z matrix and the second equalized R matrix.

At operation S63, conjugate transpose of the second $Q_s$ matrix is multiplied by the received signal to obtain a second $Z_s$ matrix, the second $R_s$ matrix is normalized to obtain a second equalized $R_s$ matrix, and a second equalized signal corresponding to the received signal is determined based on the second $Z_s$ matrix and the second equalized $R_s$ matrix.

At operation S64, a first swapped ML path search process is performed based on the first equalized signal and the second equalized signal.

According to the embodiment of the present disclosure, the first swapped ML path search process is: dividing all the nodes of the top layer into $B_1$ blocks each including one representative point and at least one extended point, performing path detection on each of the representative points, selecting $Ka_1$ representative points with minimum measurements, taking the blocks corresponding to the selected representative points as the survivor blocks, performing path detection on the extended point near the representative point in each of the survivor blocks, and selecting $N_3$ branches with minimum measurements as ML paths, where $B_1$, $Ka_1$, and $N_3$ are all natural numbers, and $B_1>Ka_1$.

At operation S65, the likelihood ratio information of each bit of each symbol of each layer is obtained based on the ML paths.

According to the embodiment of the present disclosure, after the current system layer number is determined to be equal to 2, column swapping is performed on the second channel response matrix to obtain the column-swapped second channel response matrix, orthogonal triangle QR decomposition is performed on the second channel response matrix before column swapping to obtain the second Q matrix and the second R matrix, and orthogonal triangle QR decomposition is performed on the column-swapped second channel response matrix to obtain the second $Q_s$ matrix and the second $R_s$ matrix; the conjugate transpose of the second Q matrix is multiplied by the received signal to obtain the second Z matrix, the second R matrix is normalized to obtain the second equalized R matrix, and the first equalized signal corresponding to the received signal is determined based on the second Z matrix and the second equalized R matrix; the conjugate transpose of the second $Q_s$ matrix is multiplied by the received signal to obtain the second $Z_s$ matrix, the second $R_s$ matrix is normalized to obtain the second equalized $R_s$ matrix, and the second equalized signal corresponding to the received signal is determined based on the second $Z_s$ matrix and the second equalized $R_s$ matrix. Thus, the SD search processes for the different layer numbers are provided, that is, when the system layer number is greater than 2, the method of sorting the columns (i.e., Nt) of the H matrix based on the energy and placing the layer with the minimum energy at the topmost layer of SD search is provided in QR decomposition; and when the system layer number is equal to 2, the method of performing column swapping on the H matrix and respectively performing QR decomposition is provided, so that ML search of SD can be performed on both layers. The search processes, which are low in complexity and can meet requirements of practical applications, for the different layer numbers are provided in the search stage, for example, when the system layer number is greater than 2, the SD search process including the ML search and the ML complementary search is adopted; and when the system layer number is equal to 2, the SD search process including the swapped ML search is adopted, so that the hardware implementation resources and power consumption is effectively reduced, and the requirements of real-time performance and throughput rate are met. The architecture provided in the embodiment of the present disclosure is flexible and can be easily scaled, so that the SD search processes according to the embodiment of the present disclosure can approach to the theoretical ML detection performance, and can be applied to the detection methods for MIMO under the condition that the number of layers and the modulation modes are continuously increased in the current and future wireless communication systems.

According to the embodiment of the present disclosure, after determining the second equalized signal corresponding to the received signal based on the second $Z_s$ matrix and the second equalized $R_s$ matrix (i.e., operation S63), the method further includes: in response to the modulation mode of the current system being the first modulation mode, performing the operation of performing the first swapped ML path search process based on the first equalized signal and the second equalized signal (i.e., operation S64); and in response to the modulation mode of the current system being the second modulation mode, performing a second swapped ML path search process based on the first equalized signal and the second equalized signal.

According to the embodiment of the present disclosure, the second swapped ML path search process is performing path detection on all the nodes of the top layer and selecting $N_4$ branches with minimum measurements as the ML paths, where $N_4$ is a natural number. Then, the operation of obtaining the likelihood ratio information of each bit of each symbol of each layer based on the ML paths (i.e., operation S65) is performed.

According to the present embodiment, when the modulation mode of the current system is determined to be the first modulation mode, the operation of performing the first swapped ML path search process based on the first equalized signal and the second equalized signal is performed; and when the modulation mode of the current system is determined to be the second modulation mode, the second swapped ML path search process is performed based on the first equalized signal and the second equalized signal, thereby providing the SD search processes for the different modulation modes. When the modulation order is greater than or equal to the preset value (for example, the preset value is 256QAM), the modulation mode is a high-order modulation mode (i.e., the first modulation mode), and the SD computation amount under the modulation mode is relatively large, so the block search method for the top layer is adopted to reduce the SD computation amount; and when the modulation order is less than the preset value, the modulation mode is a low-order modulation mode (i.e., the second modulation mode), and the SD computation amount under the modulation mode is relatively small, so that the block search method for the top layer is not needed, all the constellation points of the top layer can be subjected to the search, and the block division is not needed. Thus, the decoding detection performance of SD is effectively ensured on the basis of reducing the SD computation amount, so that the SD search processes according to the embodiment of the present disclosure can approach to the theoretical ML detection performance, and can be applied to the detection methods for MIMO under the condition that the number of layers and the modulation modes are continuously increased in the current and future wireless communication systems, including the wireless communication systems of 5G evolution, WIFI evolution, and the current 4G and 5G. Meanwhile, the complexity is low, the hardware implementation is facilitated, and the hardware implementation resources and power consumption is effectively reduced.

In order to facilitate the understanding of the technical concept or technical principle of the embodiments of the present disclosure, a specific embodiment of the SD detection method is illustrated below.

Referring to FIG. 3, it should be understood that a general SD detection process for MIMO is as follows:

1. After a channel estimation process is completed, an H matrix (i.e., the channel response matrix) with Nr*Nt dimensions is output, with Nr denotes receiving antennas and Nt denotes transmitting antennas, No (noise value) is output, and Y denotes receiving antenna data (i.e., the received signal) and is a matrix of Nr*1;
2. A QR decomposition module performs QR decomposition (i.e., orthogonal triangle QR decomposition) on the H matrix, and outputs a Q matrix and an R matrix;
3. A preprocessing module multiplies transpose of Q matrix (i.e., the conjugate transpose of the Q matrix) by Y, outputs a Z matrix, multiplies the R matrix by c (i.e., the constellation-point modulation amplitude factor), and outputs a normalized R matrix (i.e., the equalized R matrix);
4. A search module performs search using the input Z matrix and the normalized R matrix, and outputs a measurement value of each bit;
5. A soft bit calculation module generates soft bit information (i.e., the likelihood ratio information of each bit) based on the measurement values.

The SD detection method and apparatus for MIMO provided in the embodiments of the present disclosure both involve: QR decomposition, preprocessing, search, and soft bit calculation.

In the embodiment of the present disclosure, assuming that an MIMO-OFDM system with Nt transmitting antennas and Nr receiving antennas satisfies Nt≤Nr, a received signal model may be expressed as: Y=H*X+N, where Y denotes a received signal matrix of Nr*1, H denotes a channel estimation matrix of Nr*Nt, X denotes a transmitted signal matrix of Nr* 1, and N is a noise power value.

QR decomposition (i.e., orthogonal triangle QR decomposition) operation

H = Q * R is derived by QR decomposition which sorts the H matrix of Nr*Nt output by channel estimation, where a Q matrix is characterized in that a result of multiplying transpose of Q by Q is equal to a unit matrix.

The QR decomposition operation is performed by the QR decomposition module shown in FIG. 3 in an implementation structure, and the QR decomposition module performs QR decomposition on the H matrix of Nr*Nt, and outputs the Q matrix and an R matrix.

In practical implementations, there are the following differences for different values of Nt.

When Nt=2 (that is, when the number of the transmitting antennas is equal to 2, that is, when the system layer number is equal to 2 because the number of the transmitting antennas corresponds to and is the same as the system layer number), the H matrix (i.e., the channel response matrix) is a matrix [H0, H1] with two columns, where H0 and H1 both are column vectors having depths of Nr. QR decomposition is respectively performed on the H matrix before column swapping and after column swapping to ensure performance of a searched layer in a subsequent search, and sorting based on the energy of the columns is not needed during the QR decomposition. QR decomposition is performed on [H0, H1] before column swapping to output a Q matrix and an R matrix, and QR decomposition is performed on [H1, H0] after column swapping to output a $Q_s$ matrix and an $R_s$ matrix. The Q matrix and the $Q_s$ matrix are matrices of Nr*2, and the R matrix and the $R_s$ matrix are upper triangular matrices of 2*2 matrices, as shown in FIG. 4.

When Nt>2 (that is, when the number of the transmitting antennas is greater than 2, that is, when the system layer number is greater than 2 because the number of the transmitting antennas corresponds to and is the same as the system layer number), the column-swapped H matrix does not need to be subjected to QR decomposition. Sorting based on the energy of the columns is needed during QR decomposition, and the energy of the column $Q_{Nt-1}$ is the lowest when the output Q matrix is [$Q_0$, $Q_1$ ... $Q_{Nt-1}$],; and the R matrix is an upper triangular matrix of Nt*Nt.

The state flow (shown in FIG. 5) implemented by the QR decomposition module is described below by taking a scenario where Nt≤4 as an example.

Nt is determined after the system is started. If Nt=4, stage0 is entered, energy-based sorting and column swapping of the four columns of the H matrix are performed, and a first column of the Q matrix and a first row of the R matrix are calculated; then stage1 is entered, energy-based sorting and column swapping of the remaining three columns are performed, a second column of the Q matrix and a second row of the R matrix are calculated, and so on to enter stage2 and stage3; and finally, idle is returned to, and the final Q matrix and the final R matrix are output.

If Nt=3, the flow begins directly from stage1, and the subsequent operations are performed in sequence.

If Nt=2, 2L_stage0 is entered, a first column of the Q matrix obtained by the QR decomposition on the H matrix and a first row of the R matrix obtained by the QR decomposition on the H matrix are calculated, and meanwhile, a first column of a $Q_s$ matrix obtained by the QR decomposition on the swapped H matrix and a first row of an $R_s$ matrix obtained by the QR decomposition on the swapped H matrix are calculated; then 2L_stage1 is entered, a second column of the Q matrix obtained by the QR decomposition on the H matrix and a second row of the R matrix obtained by the QR decomposition on the H matrix are calculated, and meanwhile, a second column of the $Q_s$ matrix obtained by the QR decomposition on the swapped H matrix and a second row of the $R_s$ matrix obtained by the QR decomposition on the swapped H matrix are calculated; and finally, idle is returned to, and the final Q matrix, the final $Q_s$ matrix, the final R matrix, and the final $R_s$ matrix are output.

Preprocessing operation

After the QR decomposition operation, the formula Y = Q * R * Xp + N can be derived, where Xp is a result of re-sorting based on the sorting in the QR decomposition operation.

Further, Z=R*Xs+W is derived from $Q^TY = Q^TQ * R * Xp + Q^T * N$, where $Z=Q^TY$, $W=Q^TN$, and R=R*c, and Xs is obtained after extracting the factor c from Xp.

A preprocessing structure in an implementation structure is as shown in FIG. 6. In FIG. 6, generation of Z (i.e., the Z matrix) performs a calculation of multiplying transpose of the Q matrix by the Y matrix and a calculation of multiplying transpose of the $Q_s$ matrix by the Y matrix, and outputs the Z matrix and a $Z_s$ matrix.

In normalization of R (i.e., the R matrix) and $R_s$ (i.e., the $R_s$ matrix), each element of the R matrix and each element of the $R_s$ matrix are multiplied by c which is the constellation-point modulation amplitude factor, and the normalized R matrix and the normalized $R_s$ matrix are output.

Through the preprocessing of R, the subsequent search processes can be performed merely in an integer range, which greatly reduces the computation amount and the implementation complexity of the searches.

Operation of search+soft bit calculation

The matrices are further expanded to obtain the following formula:

$$\begin{pmatrix} Z_0 \\ Z_1 \\ \vdots \\ Z_{Nt-1} \end{pmatrix} = \begin{pmatrix} R_{00} & \cdots & R_{0*(Nt-1)} \\ \vdots & \ddots & \vdots \\ 0 & \cdots & R_{(Nt-1)*(Nt-1)} \end{pmatrix} \begin{pmatrix} xs_0 \\ xs_1 \\ \vdots \\ xs_{Nt-1} \end{pmatrix} + \begin{pmatrix} w_0 \\ w_1 \\ \vdots \\ w_{Nt-1} \end{pmatrix}$$

The basic idea of the SD search process is as follows: under the condition that Z and R are determined, a value of Xs is taken from a range defined by the modulation mode, Xs which minimizes dst is found, that is, each $|\cdot|^2$ is a minimum value, and dst is referred to as a measurement value, as shown in FIG. 7. FIG. 7 shows a basic search process.

The number of all required constellation points of $xs_{Nt-1}$ is defined to be $K_{Nt-1}$. When merely an optimal point is subjected to search for $xs_{Nt-2}$, T=1 is set; and when an optimal point and a sub-optimal point are subjected to search for $xs_{Nt-2}$, T=2 is set. The search process is as follows:

1. traversing all the required $K_{Nt-1}$ constellation points of $xs_{Nt-1}$, and performing calculation to obtain $dst_{Nt-1}$;
2. under each $xs_{Nt-1}$, searching for a constellation point of $xs_{Nt-2}$ which minimizes $dst_{Nt-2}$; and when T=2, searching for a constellation point of $xs_{Nt-2}$ which causes a second smallest value of $dst_{Nt-2}$, and outputting $dst_{Nt-2}$;
3. searching for a constellation point of $xs_{Nt-3}$ which minimizes $dst_{Nt-3}$ using the obtained $xs_{Nt-1}$ and $xs_{Nt-2}$, and outputting $dst_{Nt-3}$;
4. and so on, until searching for a constellation point of $xs_0$ which minimizes $dst_0$, and outputting $dst_0$; and
5. finally obtaining $K_{Nt-1}$*T measurement values, i.e., $dst_sum = \sum_{i=0}^{K*T} dst_i$ , and the corresponding $K_{Nt-1}$*T values of Xs.

In the embodiment of the present disclosure, multiple searches such as the ML search and the ML complementary search in the SD search described below are all performed based on the basic search process illustrated by FIG.

7.

It should be noted that different SD search processes are adopted for different layer numbers and different modulation modes in practical implementations of the embodiment of the present disclosure.

(1) Operation when Nt>2

When Nt>2, the SD search adopts the process of ML search+ML complementary search, the ML search is adopted for the $xs_{Nt-1}$ layer, and the ML complementary search is adopted for all the layers below the $xs_{Nt-1}$ layer.

When the modulation order≥256QAM (that is, when the preset value is 256QAM, or the first modulation mode is a modulation mode with the modulation order greater than or equal to 256QAM), $T_{ML}$ for the ML search is set to be 1, the number of constellation points is defined to be Qm, and Qm≥256. If $K_{Nt-1}$=Qm is selected, all the constellation points of the $xs_{Nt-1}$ layer are subjected to the search, which causes a large computation amount. In practical operations, $K_{Nt-1}$ constellation points are selected from the Qm constellation points for the search in the $xs_{Nt-1}$ layer, and the $K_{Nt-1}$ constellation points are selected with the following method.

All the Qm constellation points of the $xs_{Nt-1}$ layer are divided into $B_{Nt-1}$ blocks, the number of the constellation points in each block is $b_{Nt-1}$, $Ka_{Nt-1}$ blocks are selected from the $B_{Nt-1}$ blocks, and the constellation points in the $Ka_{Nt-1}$ blocks are subjected to the search for the $xs_{Nt-1}$ layer, that is, the selected $K_{Nt-1}$= $Ka_{Nt-1}$* $b_{Nt-1}$.

The method of selecting the $Ka_{Nt-1}$ blocks is: selecting one constellation point from each of the $B_{Nt-1}$ blocks of the $xs_{Nt-1}$ layer for the search to obtain $B_{Nt-1}$ measurement values, selecting the blocks corresponding to $Ka_{Nt-1}$ minimum measurement values from the $B_{Nt-1}$ measurement values, and positioning the survivor blocks.

After the search on the $K_{Nt-1}$ constellation points is completed in the $xs_{Nt-1}$ layer, $Kt_{Nt-1}$=$K_{Nt-1}$*$T_{ML}$ measurement values and $Kt_{Nt-1}$ values of Xs are obtained. For each bit of the constellation points of the $xs_{Nt-1}$ layer, the minimum measurement values among the $Kt_{Nt-1}$ measurement values which make each bit be 0 and 1 are reserved for the subsequent soft bit calculation.

The ML search is performed merely on the constellation points required by the $xs_{Nt-1}$ layer but not on the constellation points required by the layers below the $xs_{Nt-1}$ layer, that is, the $Kt_{Nt-1}$ values of Xs are obtained by the ML search, $xs_{Nt-2}$ to $xs_0$ in which may not be the finally required constellation points, so the $xs_{Nt-2}$layer to the $xs_0$ layer need to be subjected to the ML complementary search, and $T_{MLC}$ is set to be 1.

In the ML search stage, Nitr minimum measurement values are selected from the $Kt_{Nt-1}$ measurement values, Nitr values of Xs corresponding to the Nitr minimum measurement values are selected, and the selected Nitr minimum measurement values and Nitr values of Xs are defined as survivor paths. j denotes a number of a layer subjected to the complementary search, and j ∈ [0, Nt - 2]. In the ML complementary search stage, based on the constellation points of the $xs_j$ layer stored in the Nitr survivor paths and the constellation points of $xs_{Nt-1}$ to $xs_{j+1}$, the constellation points near the $xs_j$ layer are subjected to the search based on the search process illustrated by FIG. 7, the constellation points near the $xs_j$ layer are obtained by looking up a table, and the number of the constellation points near the $xs_j$ layer is related to a modulation mode of the $xs_j$ layer, and is denoted by $m_j$. The number of the constellation points of the $xs_j$ layer which are subjected to the complementary search is set to be $Kt_j$, then the number of times of the ML complementary searches in the $xs_j$ layer is $Kt_j$=Nitr*$m_j$*$T_{MLC}$, $Kt_j$ measurement values are obtained, and for the $xs_j$ layer, the minimum measurement values among the $Kt_j$ measurement values which make each bit of the constellation points be 0 and 1 are reserved for the subsequent soft bit calculation.

When the modulation order is 64QAM, 16QAM, or QPSK (that is, when the preset value is 256QAM, or the second modulation mode is a modulation mode with the modulation order less than 256QAM), it is set that $K_{Nt-1}$=Qm, where Qm=64, 16, or 4, that is, all the constellation points in the $xs_{Nt-1}$ layer are subjected to the search, and do not need to be divided into blocks. $T_{ML}$ is set to be 2, $T_{MLC}$ is set to be 1, and the rest of the search process is the same as that described above.

(2) Operation when Nt=2

When Nt=2, the SD search adopts the swapped ML search.

When the modulation order≥256QAM, $T_{ML}$ for the ML search is set to be 1, the number of constellation points is defined to be Qm, and Qm≥256. If $K_1$=Qm is selected, all the constellation points of the $xs_1$ layer are subjected to the search, which causes a large computation amount. Actually, $K_1$ constellation points are selected from the Qm constellation points for the search in the $xs_1$ layer, and the $K_1$ constellation points are selected with the following method.

All the Qm constellation points of the $xs_1$ layer are divided into $B_1$ blocks, the number of the constellation points in each block is $b_1$, $Ka_1$ blocks are selected from the $B_1$ blocks, and the constellation points in the $Ka_1$ blocks are subjected to the search for the $xs_1$layer, that is, the selected $K_1$= $Ka_1$* $b_1$.

The method of selecting the $Ka_1$ blocks is: selecting one constellation point from each of the $B_1$ blocks of the $xs_1$ layer for the search to obtain $B_1$ measurement values, selecting the blocks corresponding to $Ka_1$ minimum measurement

values from the $B_1$ measurement values, and positioning the survivor blocks.

After the search on the $K_1$ constellation points is completed in the $xs_1$ layer, $Kt_1=K_1*T_{ML}$ measurement values are obtained. Unlike the operation when Nt>2, there is no need to reserve $Kt_1$ values of Xs. For each bit of the constellation points of the $xs_1$ layer, the minimum measurement values among the $Kt_1$ measurement values which make each bit be 0 and 1 are reserved for the subsequent soft bit calculation.

Adopting the ML complementary search similar to that in the operation when Nt>2 cannot achieve the performance, so that the above ML search for the $xs_1$ layer is also applied to the ML search for the $xs_0$ layer, which is not described in detail here.

When the modulation order is 64QAM, 16QAM, or QPSK, it is set that $K_1$=Qm and $K_0$=Qm, where Qm=64, 16, or 4. All the constellation points in the $xs_1$ layer and the $xs_0$ layer are subjected to the search, and do not need to be divided into blocks. $T_{ML}$ is set to be 1, and the rest of the search process is the same as that described above.

In the embodiment of the present disclosure, a soft bit is defined to be denoted by LLR, and the soft bit calculation is as follows:

$$\mathrm{LLR}[j][i] = \frac{\mathrm{D0}[j][i] - \mathrm{D1}[j][i]}{\mathrm{NO}};$$

where i≤log2(Qm), j≤Nt-1, i and j are both integers, D0[j][i] denotes a minimum measurement value which makes an $i^{th}$ bit of a j layer be 0, and D1[j][i] denotes a minimum measurement value which makes the $i^{th}$ bit of the j layer be 1.

In the embodiment of the present disclosure, FIG. 8 shows an implementation architecture provided according to the above process for the search and the soft bit calculation.

In FIG. 8, LUT is a lookup table. It should be noted that the architecture in FIG. 8 supports the ML search+the ML complementary search for the operation when Nt>2, and also supports the swapped search for the operation when Nt=2.

LUT+CAL is a basic search unit. During a search, the constellation points subjected to the search are read from LUT, and sent to CAL to output the measurement values, thereby realizing completion of the whole search process through the instantiated basic search unit in the architecture; and LUT pre-stores the constellation points to be subjected to the search, and CAL outputs the measurement values of the constellation points subjected to the search.

ml search stage 1: performing inter-block search on the constellation points of the $xs_{Nt-1}$ layer, and outputting the measurement values, block numbers, and the constellation points to a storage module.

ml search stage 2: reading the $K_{Nt-1}$ survivor blocks from the storage module, performing search on the constellation points in the survivor blocks of the $xs_{Nt-1}$ layer to complete the search on the required constellation points of the $xs_{Nt-1}$ layer, and outputting the measurement values and the constellation points to the storage module.

ml complementary search: reading the reserved Nitr survivor paths from the storage module, looking up LUT based on survivor path information (constellation points), performing ML complementary search on the constellation points of the $xs_{Nt-2}$ layer to the $xs_0$ layer, and outputting the measurement values and the constellation points to the storage module.

The storage module is configured to store various information during the search processes.

In an ml search stage 1, comparison is performed, and K survivor blocks with minimum measurement values are reserved.

In the ml search stage 1 and an ml search stage 2, comparison is performed, and information of Nitr survivor paths with minimum measurement values is reserved.

In the whole search stage, the minimum measurement values when each bit of the constellation points of all the layers is 0 and 1.

Soft bit calculation: reading the minimum measurement values when each bit of each constellation point is 0 and 1 from the storage module, and calculating soft bits.

A control module schedules each search unit based on configuration information such as Nt and Qm to complete the whole search process in a pipeline manner.

In the present embodiment, it should be noted that:

I. When Nt>2, the SD search adopts the process of ML search+ML complementary search as follows: when the modulation mode≥256QAM, the following operations are sequentially performed: inter-block search in ml search stage 1 → storage → in-block search in ml search stage 2 → storage → ML complementary search → storage → soft bit calculation; when the modulation mode=64QAM, the following operations are sequentially performed: search on part of constellation points in ml search stage 1 → storage → search on remaining constellation points in ml search stage 2 → storage → ML complementary search → storage → soft bit calculation; and when the modulation mode=16QAM or QPSK, the following operations are sequentially performed: search on constellation points in ml search stage 1 → storage → ML complementary search → storage → soft bit calculation.

II. When Nt=2, the SD search adopts the swapped ML search process (without ML complementary search) as follows: when the modulation mode≥256QAM, the following operations are sequentially performed: inter-block search in ml search stage 1 → storage → in-block search in ml search stage 2 → storage → soft bit calculation; when the modulation mode=64QAM, the following operations are sequentially performed: search on part of constellation points in ml search stage 1 → storage → search on remaining constellation points in ml search stage 2 → storage → soft bit calculation; and when the modulation mode=16QAM or QPSK, the following operations are sequentially performed: search on constellation points in ml search stage 1 → storage → soft bit calculation.

The implementation structure of the present specific embodiment can be easily scaled. For example, the search computation amount in the ml search stage 2 and in the ML complementary search may be determined based on the required layer number and the modulation mode, and the matched number of instantiate search units may be selected, resulting in fast engineer implementation.

In addition, the present specific embodiment provides the SD search processes supporting multiple layers and multiple modulation modes, and the provided processes can approach to the theoretical ML detection performance, and can be applied to the detection methods for MIMO under the condition that the number of layers and the modulation modes are continuously increased in the current and future wireless communication systems, including the wireless communication systems of 5G evolution, WIFI evolution, and the current 4G and 5G. Meanwhile, the complexity is low, the hardware implementation is facilitated, and the hardware implementation resources and power consumption is effectively reduced. Moreover, the present specific embodiment provides the low-complexity architecture for implementing the MIMO detection method, the architecture is low in implementation cost and power consumption, adopts a pipeline fusion structure, is applicable to the current and future wireless communication systems with continuously increased layer number and modulation mode, and can meet the requirements of real-time performance and throughput rate. The architecture is also flexible and can be easily scaled, which facilitates fast engineering implementation.

It should be noted that the above disclosure is merely preferred embodiments of the present disclosure, and is certainly not intended to limit the scope of the present disclosure, and those of ordinary skill in the art can understand all or part of the processes for implementing the above embodiments, and equivalent changes made according to the claims still fall within the scope of the present disclosure.

That is, the above specific embodiment is merely used for facilitating the understanding of the technical principle or technical concept of the embodiments of the present disclosure, and does not constitute any limitation to the present disclosure, and various simple changes based on the technical concept should be considered to fall within the scope of the present disclosure.

In addition, an embodiment of the present disclosure further provides an SD detection apparatus as shown in FIG. 9.

In the embodiment of the present disclosure, the SD detection apparatus includes: a QR decomposition module 10, an equalized signal calculation module 20, an ML path search module 30, an ML complementary path search module 40, and a soft information calculation module 50.

The QR decomposition module 10 is configured to perform, after a current system layer number is determined to be greater than 2, orthogonal triangle QR decomposition on a first channel response matrix to obtain a first Q matrix and a first R matrix, where columns in the first Q matrix are arranged based on magnitudes of channel energy, and a column with minimum channel energy is arranged at a top layer of SD search.

The equalized signal calculation module 20 is configured to multiply conjugate transpose of the first Q matrix by a received signal to obtain a first Z matrix, normalize the first R matrix to obtain a first equalized R matrix, and determine a target equalized signal corresponding to the received signal based on the first Z matrix and the first equalized R matrix.

The ML path search module 30 is configured to perform a first ML path search process based on the target equalized signal, where the first ML path search process is dividing all nodes of the top layer into $B_{Nt-1}$ blocks each including one representative point and at least one extended point, performing path detection on each of the representative points, selecting $Ka_{Nt-1}$ representative points with minimum measurements, taking the blocks corresponding to the selected representative points as survivor blocks, performing path detection on the extended point near the representative point in each of the survivor blocks, and selecting $N_1$ branches with minimum measurements as survivor paths, $B_{Nt-1}$, $Ka_{Nt-1}$, and $N_1$ are all natural numbers, and $B_{Nt-1} > Ka_{Nt-1}$.

The ML complementary path search module 40 is configured to perform ML complementary path search on all the survivor paths to obtain ML complementary paths.

The soft information calculation module 50 is configured to take a survivor path with a minimum measurement as an ML path, and obtain likelihood ratio information of each bit of each symbol of each layer based on the ML path and the ML complementary paths.

In some embodiments, the ML path search module 30 is further configured to perform, in response to a modulation mode of a current system being a first modulation mode, an operation of performing the first ML path search process based on the target equalized signal, where a modulation order of the first modulation mode greater than or equal to a preset value; and perform, in response to the modulation mode of the current system being a second modulation mode, a second ML path search process based on the target equalized signal, where the second ML path search process is performing path detection on all the nodes of the top layer and selecting $N_2$ branches with minimum measurements as the survivor paths, a modulation order of the second modulation mode is less than the preset value, and $N_2$ is a natural number. Then, an operation of performing ML complementary path search on all the survivor paths to obtain the ML complementary paths is performed.

In some embodiments, the QR decomposition module 10 is further configured to perform, after the current system layer number is determined to be equal to 2, column swapping on a second channel response matrix to obtain a column-swapped second channel response matrix, perform orthogonal triangle QR decomposition on the second channel response matrix before column swapping to obtain a second Q matrix and a second R matrix, and perform orthogonal triangle QR decomposition on the column-swapped second channel response matrix to obtain a second $Q_s$ matrix and a second $R_s$ matrix.

The equalized signal calculation module 20 is further configured to multiply conjugate transpose of the second Q matrix by the received signal to obtain a second Z matrix, normalize the second R matrix to obtain a second equalized R matrix, and determine a first equalized signal corresponding to the received signal based on the second Z matrix and the second equalized R matrix; and multiply conjugate transpose of the second $Q_s$ matrix by the received signal to obtain a second $Z_s$ matrix, normalize the second $R_s$ matrix to obtain a second equalized $R_s$ matrix, and determine a second equalized signal corresponding to the received signal based on the second $Z_s$ matrix and the second equalized $R_s$ matrix.

The ML path search module 30 is further configured to perform a first swapped ML path search process based on the first equalized signal and the second equalized signal, where the first swapped ML path search process is dividing all the nodes of the top layer into $B_1$ blocks each including one representative point and at least one extended point, performing path detection on each of the representative points, selecting $Ka_1$ representative points with minimum measurements, taking the blocks corresponding to the selected representative points as the survivor blocks, performing path detection on the extended point near the representative point in each of the survivor blocks, and selecting $N_3$ branches with minimum measurements as ML paths, $B_1$, $Ka_1$, and $N_3$ are all natural numbers, and $B_1 > Ka_1$.

The soft information calculation module 50 is further configured to obtain the likelihood ratio information of each bit of each symbol of each layer based on the ML paths.

In some embodiments, the ML path search module 30 is further configured to perform, in response to the modulation mode of the current system being the first modulation mode, an operation of performing the first swapped ML path search process based on the first equalized signal and the second equalized signal; and perform, in response to the modulation mode of the current system being the second modulation mode, a second swapped ML path search process based on the first equalized signal and the second equalized signal, where the second swapped ML path search process is performing path detection on all the nodes of the top layer and selecting $N_4$ branches with minimum measurements as the ML paths, and $N_4$ is a natural number. Then, an operation of deriving the likelihood ratio information of each bit of each symbol of each layer based on the ML paths is performed.

In some embodiments, the ML complementary path search module 40 is further configured to perform, for each layer below the top layer, path extension on all the survivor paths, and select, from branches generated by path extension, the branches with minimum measurements as the ML complementary paths.

In some embodiments, the ML path search module 30 is further configured to generate a constellation diagram based on the target equalized signal, and divide all the nodes of the top layer into the $B_{Nt-1}$ blocks based on the constellation diagram.

An operation of performing path detection on the extended point near the representative point in each survivor block includes: performing extended search on the extended point around the representative point in each of the survivor blocks, where the extended point subjected to extended search in each of the survivor blocks is uniformly extended outwards by taking the representative point as a center.

In some embodiments, the equalized signal calculation module 20 is further configured to multiply the first R matrix by a constellation-point modulation amplitude factor to obtain a normalized first R matrix, and taking the normalized first R matrix as the first equalized R matrix.

The SD detection apparatus provided in the embodiments of the present disclosure and the SD detection method provided in the aforesaid embodiments of the present disclosure belong to the same inventive concept, reference may be made to the aforesaid embodiments of the SD detection method for the technical details which are not described in the present embodiment, the present embodiment has the same beneficial effects as the aforesaid embodiments of the SD detection method, and the beneficial effects of the present embodiment will not be repeated here.

The embodiments of the apparatus described above are merely for illustration, the units in the apparatus described as separate parts may be physically separate or not, that is, those units may be located in one place or distributed in a plurality of network units. Some or all of the modules in the apparatus may be selected based on actual needs to achieve the objectives of the technical solutions of the embodiments.

As shown in FIG. 10 which shows a commonly used wireless receiving device supporting MIMO-OFDM, signals are received from receiving antennas and are subjected to digital front-end processing and Fast Fourier Transform (FFT) to output frequency-domain data; the frequency-domain data is sent to a channel estimation module, the channel estimation module performs processing and outputs an H matrix (a channel impulse response matrix) to an MIMO detection module; the MIMO detection module performs detection and outputs LLR to a decoder, and the decoder performs processing and outputs decoded bits. The SD detection method provided in the embodiments of the present disclosure can be applied to the MIMO detection module of the wireless receiving device. The embodiments of the present disclosure are applicable to a terminal receiver, and are also applicable to a base station receiver. By adopting the embodiments of the present disclosure, the MIMO detection can achieve the performance approaching to the ML detection performance, and meanwhile, the complexity is greatly reduced, which endows the MIMO detection with realizability.

FIG. 11 is a schematic diagram of a hardware structure of an electronic device according to an embodiment of the present disclosure. As shown in FIG. 11, the electronic device may include: a processor 1001 such as a Central Processing Unit (CPU), a communication bus 1002, a user interface 1003, a network interface 1004, and a storage device 1005. The communication bus 1002 is configured to enable connection and communication between the components. The user interface 1003 may include a display and an input unit such as a keyboard. Optionally, the user interface 1003 may further include a standard wired interface and a standard wireless interface. The network interface 1004 may include, for example, a standard wired interface and a standard wireless interface (e.g., a WI-FI interface). The storage device 1005 may be a highspeed Random Access Memory (RAM) or a stable Non-Volatile Memory (NVM) such as a disk memory. Optionally, the storage device 1005 may be a storage device independent of the processor 1001.

It should be understood by those of ordinary skill in the art that the structure shown in FIG. 11 does not constitute any limitation to the electronic device, and the electronic device may include more or fewer components than those shown in FIG. 11, or is provided with a combination of some components, or has different arrangement of the components. As shown in FIG. 11, the storage device 1005 as a storage medium may include an operating system, a data storage module, a network communication module, a user interface module, and an SD detection program.

In the electronic device shown in FIG. 11, the network interface 1004 is configured to perform data communication with other devices; the user interface 1003 is configured to perform data interaction with a user; and the processor 1001 and the storage device 1005 in the present embodiment may be disposed in a communication device, and the communication device calls computer programs stored in the storage device 1005 through the processor 1001, and performs the SD detection method provided in any of the above embodiments.

The electronic device provided in the present embodiment and the SD detection method provided in the aforesaid embodiments belong to the same inventive concept, reference may be made to the aforesaid embodiments for the technical details which are not described in the present embodiment, and the present embodiment has the same beneficial effects as those produced by performing the SD detection method.

In addition, an embodiment of the present disclosure further provides a readable storage medium, which is a computer-readable storage medium, the computer-readable storage medium may be a non-volatile computer-readable storage medium, and the computer-readable storage medium has stored thereon a computer program which, when executed by a processor, cause the processor to implement the above SD detection method of the present disclosure.

Reference may be made to the embodiments of the SD detection method of the present disclosure for the embodiments of the electronic device and the computer-readable storage medium of the present disclosure, and the embodiments of the electronic device and the computer-readable storage medium of the present disclosure will not be described in detail here.

It should be noted that the terms "includes", "comprises" or any other variation thereof used in the present disclosure are intended to indicate a non-exclusive inclusion, so that a process, method, article, or system, which includes a series of elements, does not only include those elements but also include other elements which are not explicitly listed or the elements inherent in such process, method, article, or system. If there are no more limitations, limiting an element by "including a..." does not exclude the existence of other identical elements in the process, method, article, or system which includes the element.

The ordinal numbers of the above embodiments of the present disclosure are merely for description, and do not indicate a preferential order of the embodiments.

Through the above description of the implementations, those of ordinary skill in the art can understand clearly that the method according to the above embodiments may be implemented by software together with a necessary general-purpose hardware platform, and may also be implemented by hardware, but the former is better in many cases. Based on such understanding, the technical solutions of the present disclosure or a part of the technical solutions of the present disclosure which contributes to the existing technology may be implemented in a form of a software product, and the computer software product is stored in a storage medium as described above (such as a Read-Only Memory (ROM)/Random Access Memory (RAM), a magnetic disk, or an optical disc), and includes several instructions to enable an electronic device (which may be a mobile phone, a computer, a server, an air conditioner, or a network device) to perform the method described in each embodiment of the present disclosure.

What is described above is just the preferable embodiments of the present disclosure, and is not intended to limit the scope of the present disclosure, and all equivalent structure or equivalent flow transformations derived from the contents of the description and the drawings of the present disclosure or direct/indirect applications of the contents of the description and the drawings of the present disclosure to other related technical fields should be included in the scope of the present disclosure.

## Claims

1. A sphere decoding detection method, comprising:

   performing, after a current system layer number is determined to be greater than 2, orthogonal triangle QR decomposition on a first channel response matrix to obtain a first Q matrix and a first R matrix, wherein columns in the first Q matrix are arranged based on magnitudes of channel energy, and a column with minimum channel energy is arranged at a top layer of sphere decoding search;
   multiplying conjugate transpose of the first Q matrix by a received signal to obtain a first Z matrix, normalizing the first R matrix to obtain a first equalized R matrix, and determining a target equalized signal corresponding to the received signal based on the first Z matrix and the first equalized R matrix;
   performing a first Maximum Likelihood, called ML, path search process based on the target equalized signal, wherein the first ML path search process is dividing all nodes of the top layer into $B_{Nt-1}$ blocks each comprising one representative point and at least one extended point, performing path detection on each of the representative points, selecting $Ka_{Nt-1}$ representative points with minimum measurements, taking the blocks corresponding to the selected representative points as survivor blocks, performing path detection on the at least one extended point near the representative point in each of the survivor blocks, and selecting $N_1$ branches with minimum measurements as survivor paths, wherein $B_{Nt-1}$, $Ka_{Nt-1}$, and $N_1$ are all natural numbers, and $B_{Nt-1} > Ka_{Nt-1}$;
   performing ML complementary path search on all the survivor paths to obtain ML complementary paths; and
   taking a survivor path with a minimum measurement as an ML path, and obtaining likelihood ratio information of each bit of each symbol of each layer based on the ML path and the ML complementary paths.

2. The sphere decoding detection method of claim 1, wherein after determining the target equalized signal corresponding to the received signal based on the first Z matrix and the first equalized R matrix, the method further comprises:

   in response to a modulation mode of a current system being a first modulation mode, performing the operation of performing the first ML path search process based on the target equalized signal, wherein a modulation order of the first modulation mode is greater than or equal to a preset value; and
   in response to the modulation mode of the current system being a second modulation mode, performing a second ML path search process based on the target equalized signal, wherein the second ML path search process is performing path detection on all the nodes of the top layer and selecting $N_2$ branches with minimum measurements as the survivor paths, wherein a modulation order of the second modulation mode is less than the preset value, $N_2$ is a natural number, and then, the operation of performing ML complementary path search on all the survivor paths to obtain the ML complementary paths is performed.

3. The sphere decoding detection method of claim 1, further comprising:

   after the current system layer number is determined to be equal to 2, performing column swapping on a second channel response matrix to obtain a column-swapped second channel response matrix, performing orthogonal triangle QR decomposition on the second channel response matrix before column swapping to obtain a second Q matrix and a second R matrix, and performing orthogonal triangle QR decomposition on the column-swapped second channel response matrix to obtain a second $Q_s$ matrix and a second $R_s$ matrix;
   multiplying conjugate transpose of the second Q matrix by the received signal to obtain a second Z matrix, normalizing the second R matrix to obtain a second equalized R matrix, and determining a first equalized signal corresponding to the received signal based on the second Z matrix and the second equalized R matrix;
   multiplying conjugate transpose of the second $Q_s$ matrix by the received signal to obtain a second $Z_s$ matrix, normalizing the second $R_s$ matrix to obtain a second equalized $R_s$ matrix, and determining a second equalized signal corresponding to the received signal based on the second $Z_s$ matrix and the second equalized $R_s$ matrix;
   performing a first swapped ML path search process based on the first equalized signal and the second equalized signal, wherein the first swapped ML path search process is dividing all the nodes of the top layer into $B_1$ blocks each comprising one representative point and at least one extended point, performing path detection on each of the representative points, selecting $Ka_1$ representative points with minimum measurements, taking the blocks corresponding to the selected representative points as the survivor blocks, performing path detection on the at least one extended point near the representative point in each of the survivor blocks, and selecting $N_3$ branches with minimum measurements as ML paths, wherein $B_1$, $Ka_1$, and $N_3$ are all natural numbers, and $B_1 > Ka_1$; and obtaining the likelihood ratio information of each bit of each symbol of each layer based on the ML paths.

**4.** The sphere decoding detection method of claim 3, wherein after determining the second equalized signal corresponding to the received signal based on the second $Z_s$ matrix and the second equalized $R_s$ matrix, the method further comprises:

in response to a modulation mode of a current system being a first modulation mode, performing the operation of performing the first swapped ML path search process based on the first equalized signal and the second equalized signal; and
in response to the modulation mode of the current system being a second modulation mode, performing a second swapped ML path search process based on the first equalized signal and the second equalized signal, wherein the second swapped ML path search process is performing path detection on all the nodes of the top layer and selecting $N_4$ branches with minimum measurements as the ML paths, $N_4$ is a natural number, and then, the operation of obtaining the likelihood ratio information of each bit of each symbol of each layer based on the ML paths is performed.

**5.** The sphere decoding detection method of claim 1 or 2, wherein performing ML complementary path search on all the survivor paths to obtain the ML complementary paths comprises:
for each layer below the top layer, performing path extension on all the survivor paths, and selecting, from branches generated by path extension, the branches with minimum measurements as the ML complementary paths.

**6.** The sphere decoding detection method of claim 1, wherein dividing all the nodes of the top layer into the $B_{Nt-1}$ blocks comprises:

generating a constellation diagram based on the target equalized signal, and dividing all the nodes of the top layer into the $B_{Nt-1}$ blocks based on the constellation diagram, and
performing path detection on the at least one extended point near the representative point in each of the survivor blocks comprises:
performing extended search on the at least one extended point around the representative point in each of the survivor blocks, wherein the at least one extended point subjected to extended search in each of the survivor blocks is uniformly extended outwards by taking the representative point as a center.

**7.** The sphere decoding detection method of claim 1, wherein normalizing the first R matrix to obtain the first equalized R matrix comprises:
multiplying the first R matrix by a constellation-point modulation amplitude factor to obtain a normalized first R matrix, and taking the normalized first R matrix as the first equalized R matrix.

**8.** A sphere decoding detection apparatus, comprising:

a QR decomposition module configured to perform, after a current system layer number is determined to be greater than 2, orthogonal triangle QR decomposition on a first channel response matrix to obtain a first Q matrix and a first R matrix, wherein columns in the first Q matrix are arranged based on magnitudes of channel energy, and a column with minimum channel energy is arranged at a top layer of sphere decoding search;
an equalized signal calculation module configured to multiply conjugate transpose of the first Q matrix by a received signal to obtain a first Z matrix, normalize the first R matrix to obtain a first equalized R matrix, and determine a target equalized signal corresponding to the received signal based on the first Z matrix and the first equalized R matrix;
an ML path search module configured to perform a first ML path search process based on the target equalized signal, wherein the first ML path search process is dividing all nodes of the top layer into $B_{Nt-1}$ blocks each comprising one representative point and at least one extended point, performing path detection on each of the representative points, selecting $Ka_{Nt-1}$ representative points with minimum measurements, taking the blocks corresponding to the selected representative points as survivor blocks, performing path detection on the at least one extended point near the representative point in each of the survivor blocks, and selecting $N_1$ branches with minimum measurements as survivor paths, wherein $B_{Nt-1}$, $Ka_{Nt-1}$, and $N_1$ are all natural numbers, and $B_{Nt-1}$ >

$Ka_{Nt-1}$;
an ML complementary path search module configured to perform ML complementary path search on all the survivor paths to obtain ML complementary paths; and
a soft information calculation module configured to take a survivor path with a minimum measurement as an ML path, and obtain likelihood ratio information of each bit of each symbol of each layer based on the ML path and the ML complementary paths.

**9.** An electronic device, comprising: a memory, a processor, and a computer program stored on the memory, wherein the computer program, when executed by the processor, causes the processor to implement the sphere decoding detection method of any one of claims 1 to 7.

**10.** A computer-readable storage medium having stored thereon a computer program which, when executed by a processor, causes the processor to implement the sphere decoding detection method of any one of claims 1 to 7.

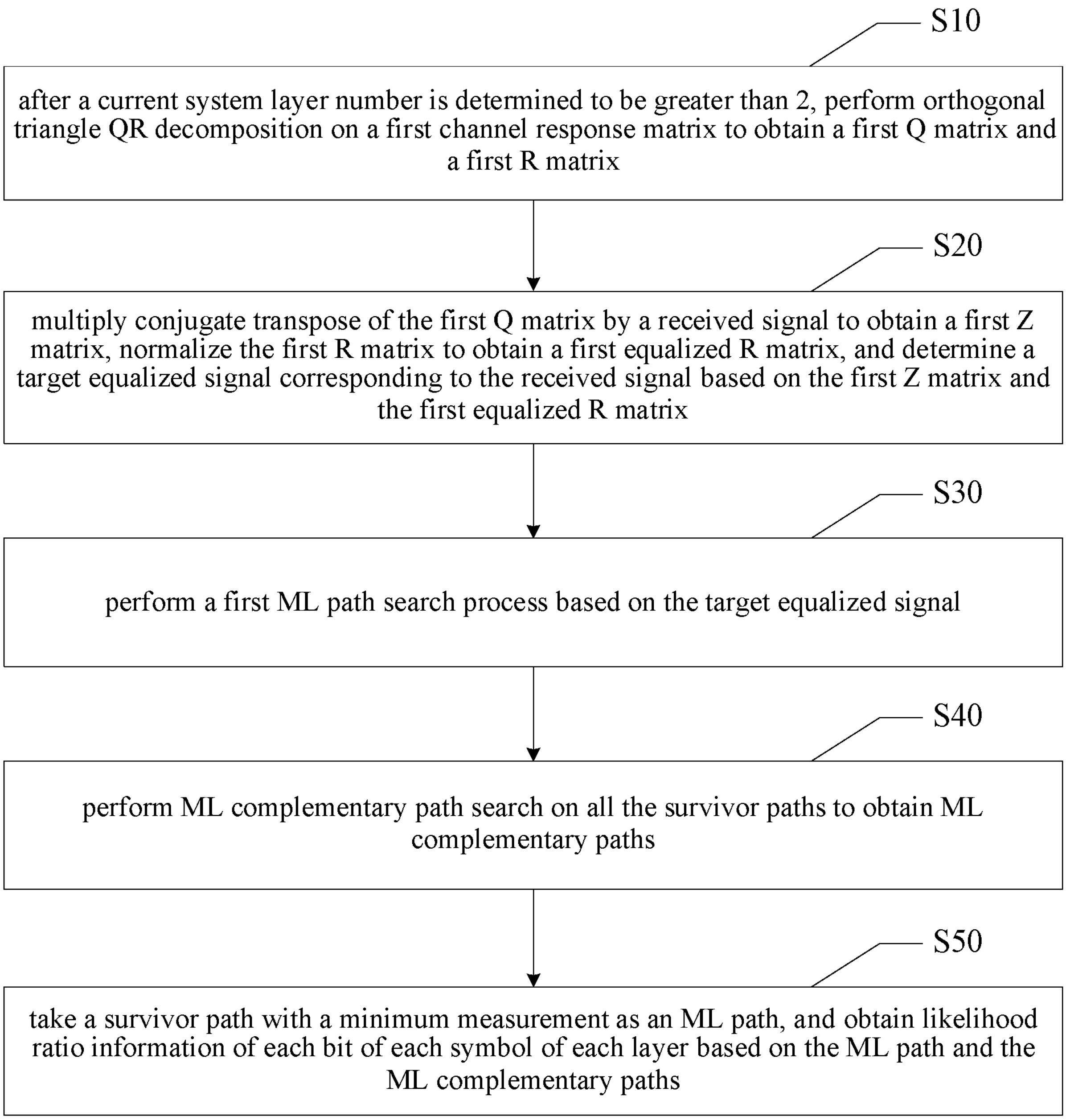
S10
after a current system layer number is determined to be greater than 2, perform orthogonal triangle QR decomposition on a first channel response matrix to obtain a first Q matrix and a first R matrix
S20
multiply conjugate transpose of the first Q matrix by a received signal to obtain a first Z matrix, normalize the first R matrix to obtain a first equalized R matrix, and determine a target equalized signal corresponding to the received signal based on the first Z matrix and the first equalized R matrix
S30
perform a first ML path search process based on the target equalized signal
S40
perform ML complementary path search on all the survivor paths to obtain ML complementary paths
S50
take a survivor path with a minimum measurement as an ML path, and obtain likelihood ratio information of each bit of each symbol of each layer based on the ML path and the ML complementary paths

FIG. 1

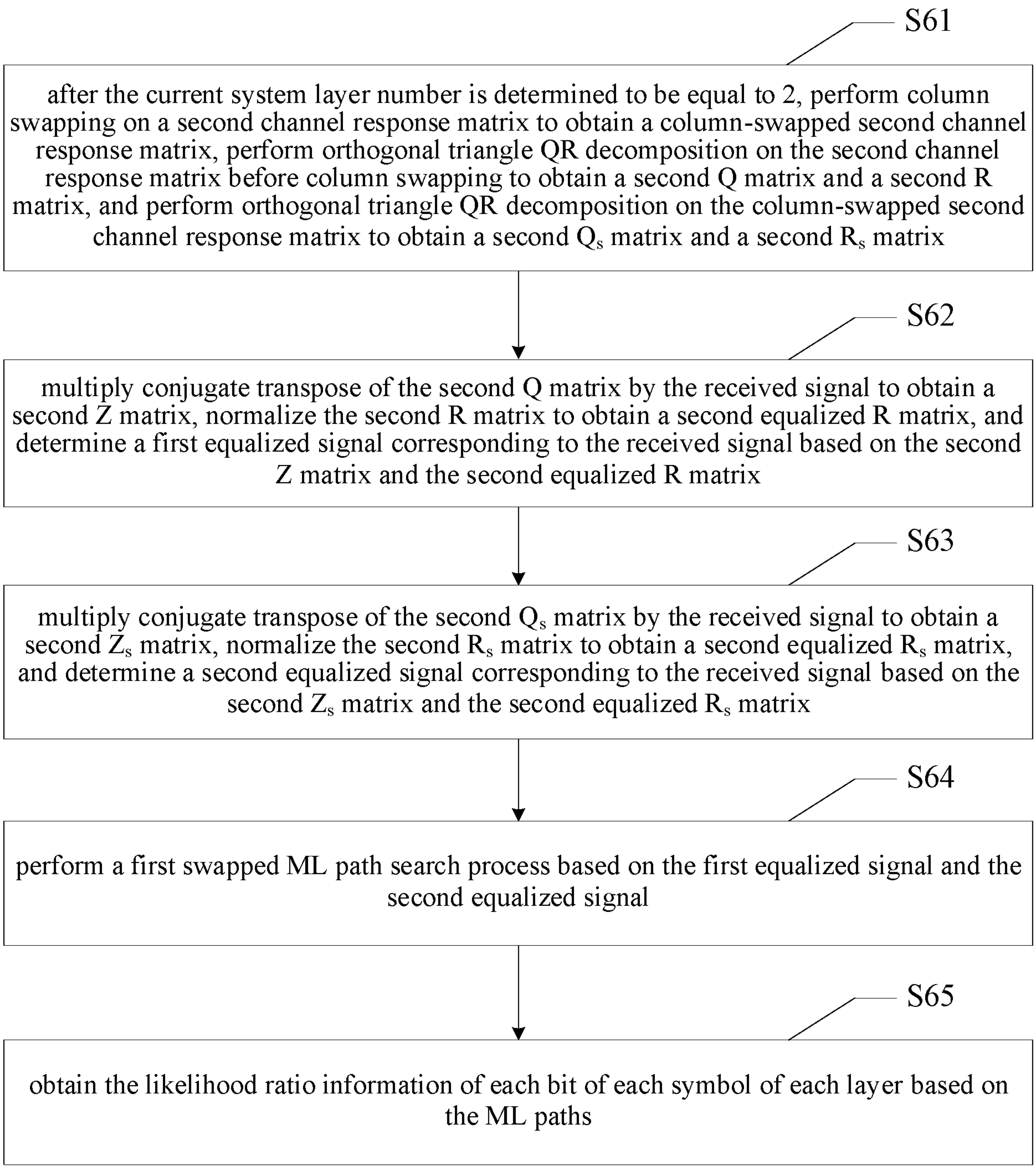
S61
after the current system layer number is determined to be equal to 2, perform column swapping on a second channel response matrix to obtain a column-swapped second channel response matrix, perform orthogonal triangle QR decomposition on the second channel response matrix before column swapping to obtain a second Q matrix and a second R matrix, and perform orthogonal triangle QR decomposition on the column-swapped second channel response matrix to obtain a second $Q_s$ matrix and a second $R_s$ matrix
S62
multiply conjugate transpose of the second Q matrix by the received signal to obtain a second Z matrix, normalize the second R matrix to obtain a second equalized R matrix, and determine a first equalized signal corresponding to the received signal based on the second Z matrix and the second equalized R matrix
S63
multiply conjugate transpose of the second $Q_s$ matrix by the received signal to obtain a second $Z_s$ matrix, normalize the second $R_s$ matrix to obtain a second equalized $R_s$ matrix, and determine a second equalized signal corresponding to the received signal based on the second $Z_s$ matrix and the second equalized $R_s$ matrix
S64
perform a first swapped ML path search process based on the first equalized signal and the second equalized signal
S65
obtain the likelihood ratio information of each bit of each symbol of each layer based on the ML paths

FIG. 2

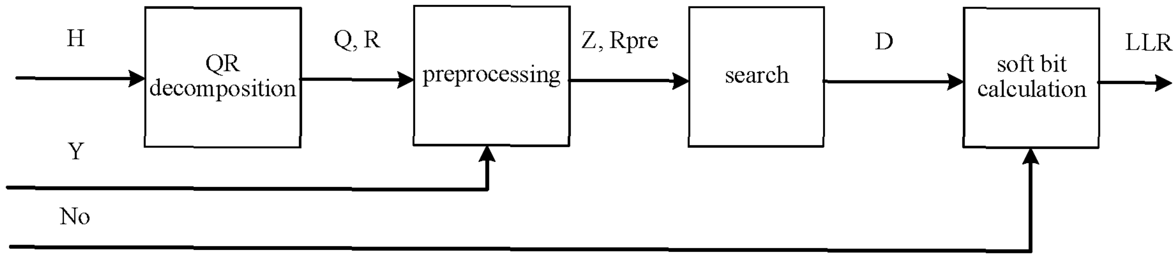
H
QR decomposition
Q, R
preprocessing
Z, Rpre
search
D
soft bit calculation
LLR
Y
No

FIG. 3

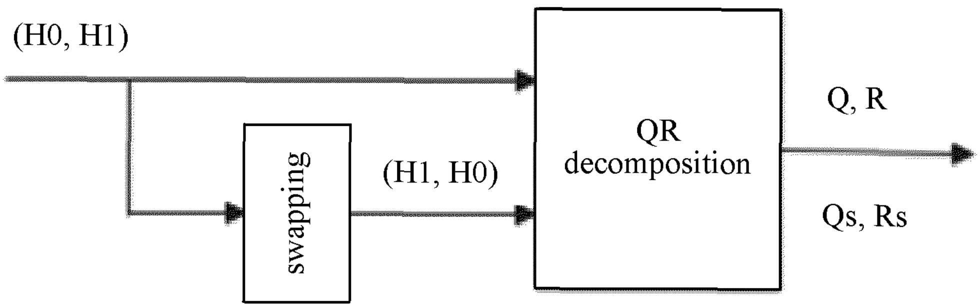
(H0, H1)
swapping
(H1, H0)
QR decomposition
Q, R
Qs, Rs

FIG. 4

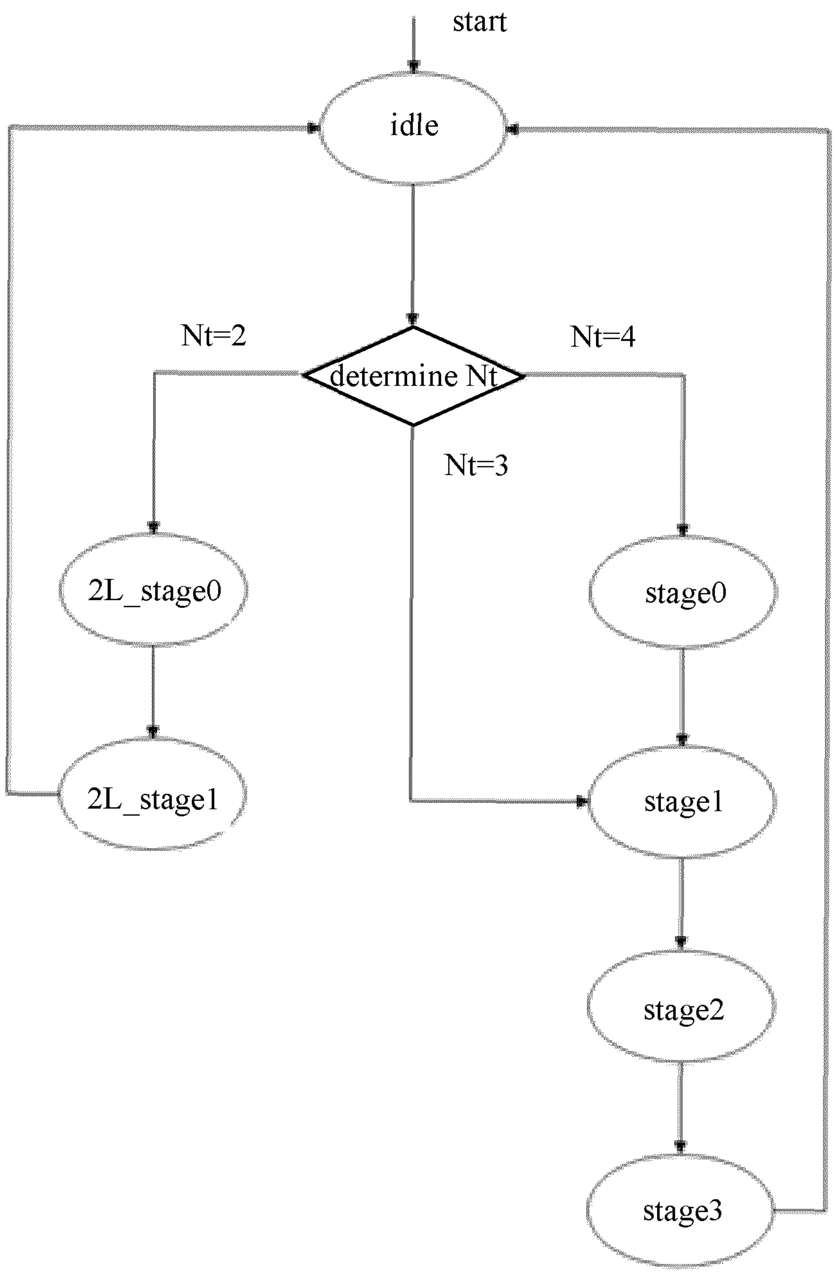
start
idle
Nt=2
determine Nt
Nt=4
Nt=3
2L_stage0
stage0
2L_stage1
stage1
stage2
stage3

FIG. 5

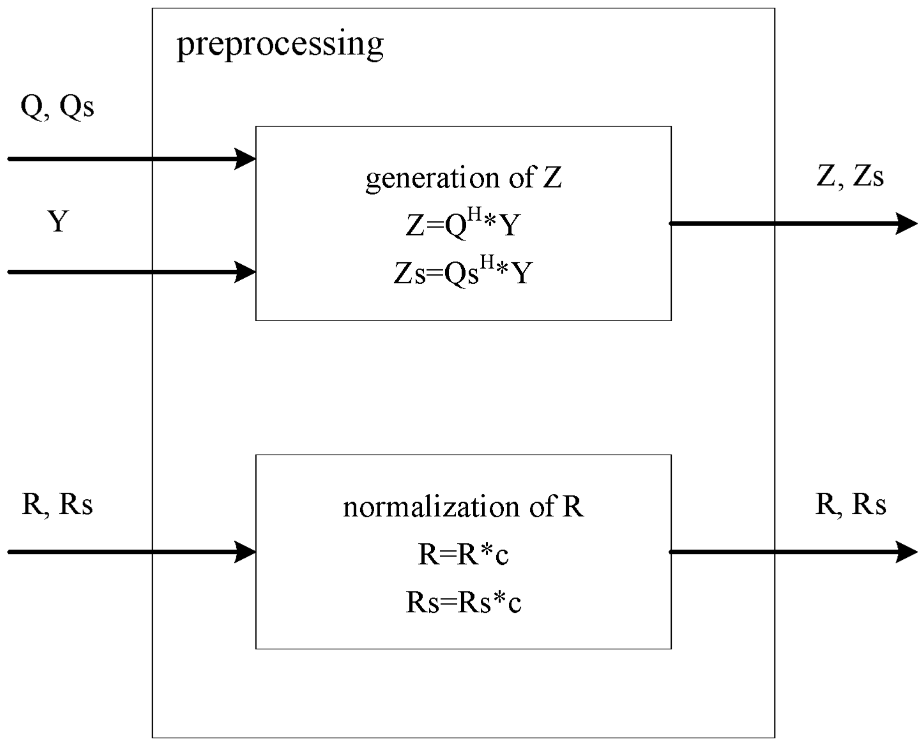
preprocessing
Q, Qs
Y
generation of Z
Z=Q^H*Y
Zs=Qs^H*Y
Z, Zs
R, Rs
normalization of R
R=R*c
Rs=Rs*c
R, Rs

FIG. 6

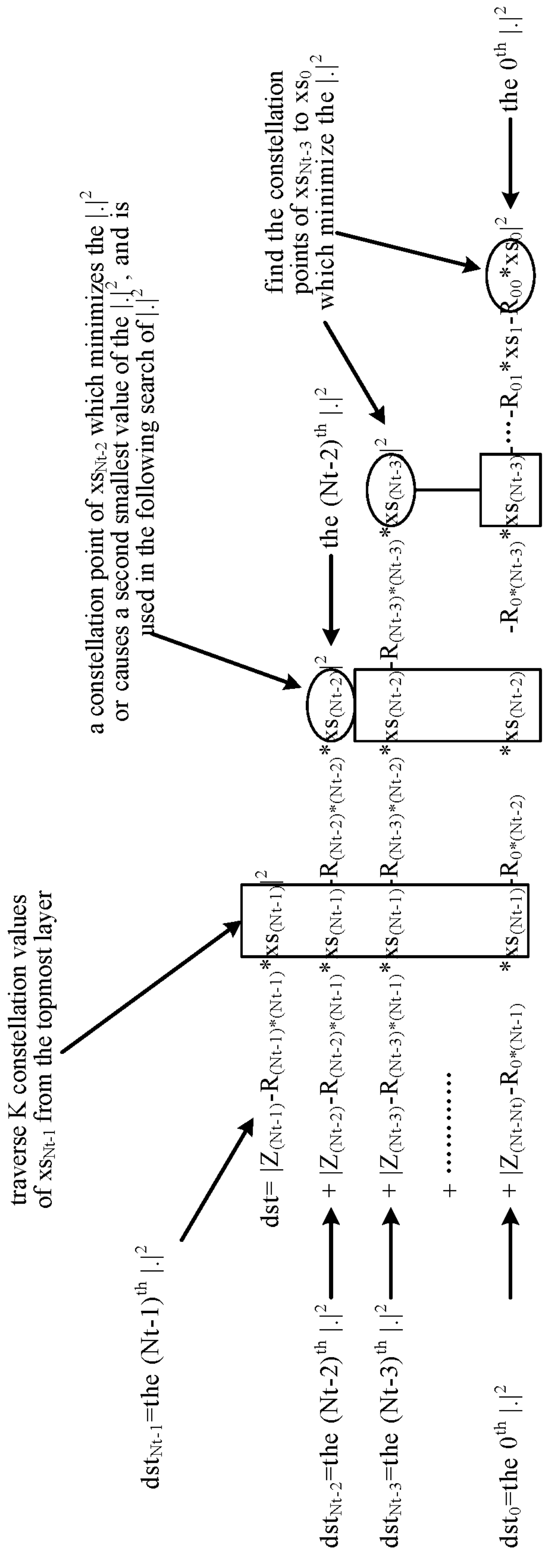
traverse K constellation values of xsNt-1 from the topmost layer
a constellation point of xsNt-2 which minimizes the |.|2 or causes a second smallest value of the |.|2, and is used in the following search of |.|2
find the constellation points of xsNt-3 to xs0 which minimize the |.|2
dstNt-1=the (Nt-1)th |.|2
dstNt-2=the (Nt-2)th |.|2
dstNt-3=the (Nt-3)th |.|2
dst0=the 0th |.|2
the (Nt-2)th |.|2
the 0th |.|2
dst= |Z(Nt-1)-R(Nt-1)*(Nt-1)*xs(Nt-1)|2
+ |Z(Nt-2)-R(Nt-2)*(Nt-1)*xs(Nt-1)-R(Nt-2)*(Nt-2)*xs(Nt-2)|2
+ |Z(Nt-3)-R(Nt-3)*(Nt-1)*xs(Nt-1)-R(Nt-3)*(Nt-2)*xs(Nt-2)-R(Nt-3)*(Nt-3)*xs(Nt-3)|2
+ ············
+ |Z(Nt-Nt)-R0*(Nt-1)*xs(Nt-1)-R0*(Nt-2)*xs(Nt-2)-R0*(Nt-3)*xs(Nt-3)-···-R01*xs1-R00*xs0|2

FIG. 7

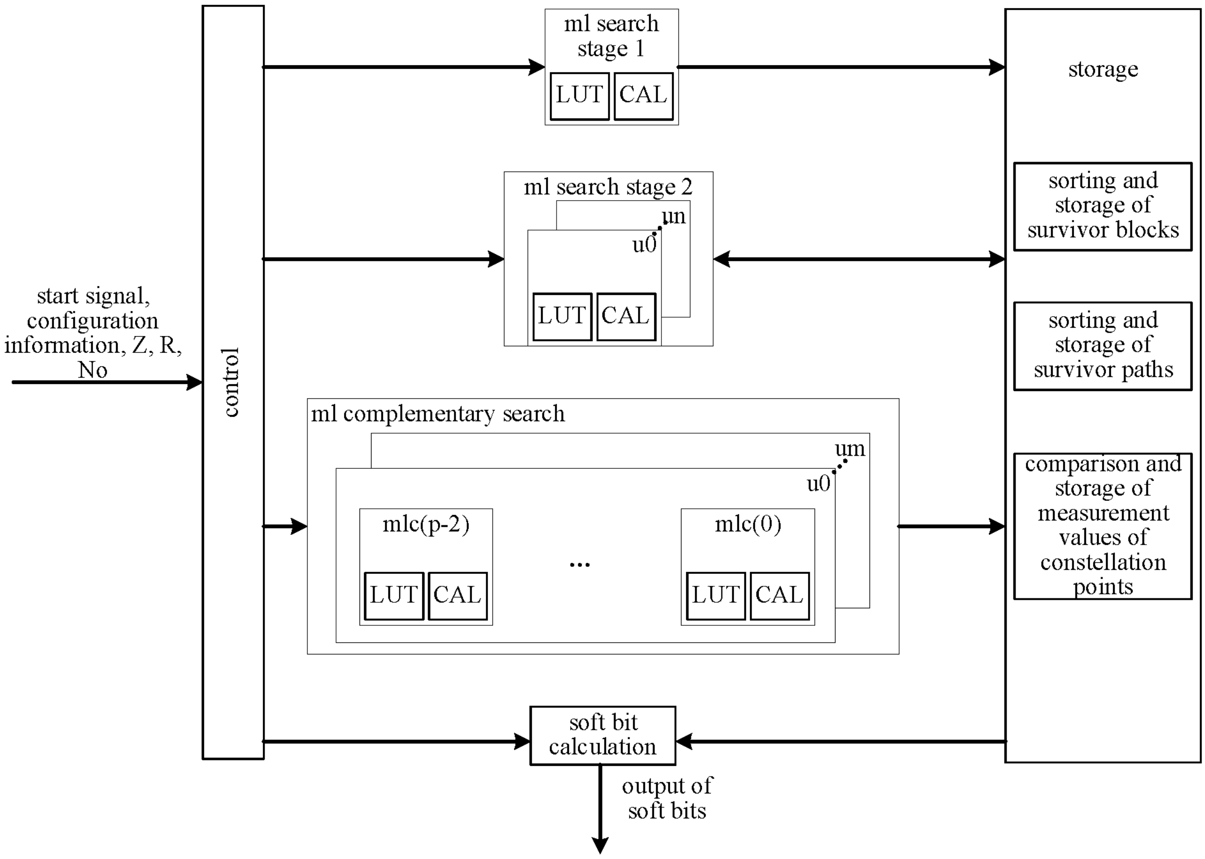
ml search stage 1
LUT
CAL
storage
ml search stage 2
un
u0
LUT
CAL
sorting and storage of survivor blocks
sorting and storage of survivor paths
start signal, configuration information, Z, R, No
control
ml complementary search
um
u0
mlc(p-2)
LUT
CAL
...
mlc(0)
LUT
CAL
comparison and storage of measurement values of constellation points
soft bit calculation
output of soft bits

FIG. 8

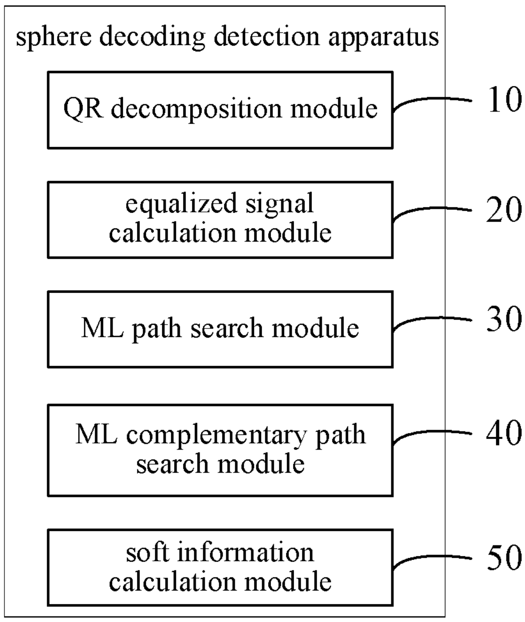
sphere decoding detection apparatus
QR decomposition module
10
equalized signal calculation module
20
ML path search module
30
ML complementary path search module
40
soft information calculation module
50

FIG. 9

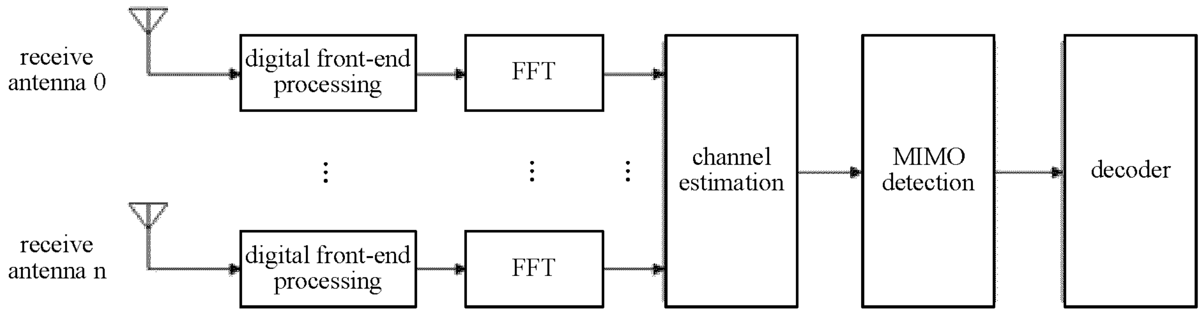
receive antenna 0
digital front-end processing
FFT
receive antenna n
digital front-end processing
FFT
channel estimation
MIMO detection
decoder

FIG. 10

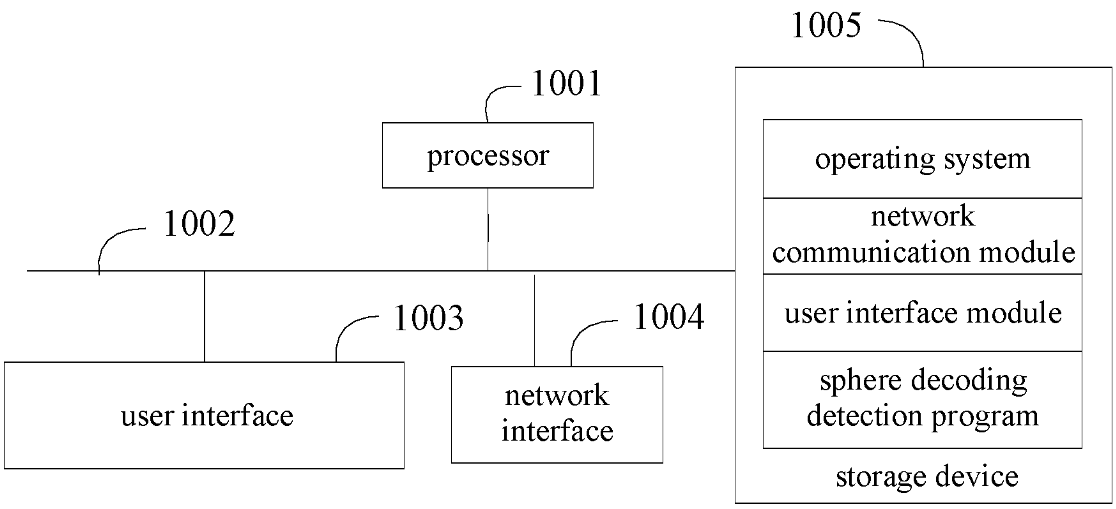
1005
1001
processor
1002
1003
1004
user interface
network interface
operating system
network communication module
user interface module
sphere decoding detection program
storage device

FIG. 11

**INTERNATIONAL SEARCH REPORT**

International application No.
**PCT/CN2023/134714**

**A. CLASSIFICATION OF SUBJECT MATTER**

H04L 25/03(2006.01)i

According to International Patent Classification (IPC) or to both national classification and IPC

**B. FIELDS SEARCHED**

Minimum documentation searched (classification system followed by classification symbols)

IPC:H04L,H04W

Documentation searched other than minimum documentation to the extent that such documents are included in the fields searched

Electronic data base consulted during the international search (name of data base and, where practicable, search terms used)

CNTXT, ENTXTC, VEN, DWPI, CNKI, IEEE, 3GPP: 球形, 解码, 译码, 检测, QR分解, 矩阵, 信道能量, 均衡, 信号, 搜索, 路径, 幸存, sphere, decoding, coding, detection, QR decomposition, matrix, channel, energy, equalization, signal, search, path, survivor

**C. DOCUMENTS CONSIDERED TO BE RELEVANT**

| Category* | Citation of document, with indication, where appropriate, of the relevant passages | Relevant to claim No. |
|---|---|---|
| A | CN 109660473 A (SHENZHEN ZTE MICROELECTRONICS TECHNOLOGY CO., LTD.) 19 April 2019 (2019-04-19)<br>entire document | 1-10 |
| A | CN 114389757 A (NANJING ZTE NEW SOFTWARE CO., LTD.) 22 April 2022 (2022-04-22)<br>entire document | 1-10 |
| A | CN 103856254 A (ZTE CORP.) 11 June 2014 (2014-06-11)<br>entire document | 1-10 |
| A | WO 2018082775 A1 (HUAWEI TECHNOLOGIES CO., LTD.) 11 May 2018 (2018-05-11)<br>entire document | 1-10 |
| A | KR 102371914 B1 (FOUNDATION FOR RESEARCH AND BUSINESS, SEOUL NATIONAL UNIVERSITY OF SCIENCE AND TECHNOLOGY) 10 March 2022 (2022-03-10)<br>entire document | 1-10 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 February 2024** | **23 February 2024** |
| Name and mailing address of the ISA/CN<br>**China National Intellectual Property Administration (ISA/CN)**<br>**China No. 6, Xitucheng Road, Jimenqiao, Haidian District, Beijing 100088** | Authorized officer<br><br>Telephone No. |

Form PCT/ISA/210 (second sheet) (July 2022)

**INTERNATIONAL SEARCH REPORT**
**Information on patent family members**

International application No.
**PCT/CN2023/134714**

| Patent document cited in search report | | | Publication date (day/month/year) | Patent family member(s) | | | Publication date (day/month/year) |
|---|---|---|---|---|---|---|---|
| CN | 109660473 | A | 19 April 2019 | CN | 109660473 | B | 28 May 2021 |
| CN | 114389757 | A | 22 April 2022 | WO | 2022078064 | A1 | 21 April 2022 |
| CN | 103856254 | A | 11 June 2014 | US | 2015304069 | A1 | 22 October 2015 |
| | | | | US | 9356733 | B2 | 31 May 2016 |
| | | | | EP | 2928084 | A1 | 07 October 2015 |
| | | | | EP | 2928084 | A4 | 09 December 2015 |
| | | | | EP | 2928084 | B1 | 06 February 2019 |
| | | | | WO | 2014082487 | A1 | 05 June 2014 |
| | | | | CN | 103856254 | B | 12 September 2017 |
| WO | 2018082775 | A1 | 11 May 2018 | | None | | |
| KR | 102371914 | B1 | 10 March 2022 | | None | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202310076293